# FASCICULE DE BREVET EUROPEEN

(11) **EP 4 060 697 B1**
(45) Date de publication et mention de la délivrance du brevet: **18.02.2026**
(21) Numéro de dépôt: 22161906.7
(22) Date de dépôt: 14.03.2022
(51) Int. Cl.: H01G 4/33, H01G 4/008, H01G 4/08, H10D 1/00, H10D 1/68, H01G 4/012, H01G 4/06, H01G 4/228

(54) **DISPOSITIF CAPACITIF A HAUTE DENSITE ET PROCEDE DE FABRICATION D'UN TEL DISPOSITIF**
KAPAZITIVE VORRICHTUNG MIT HOHER DICHTE UND VERFAHREN ZUR HERSTELLUNG EINER SOLCHEN VORRICHTUNG
HIGH-DENSITY CAPACITIVE DEVICE AND METHOD FOR MANUFACTURING SUCH A DEVICE

(30) Priorité: 18.03.2021 FR 2102733
(43) Date de publication de la demande: 21.09.2022
(73) Titulaire: Commissariat à l'Energie Atomique et aux Energies Alternatives, 75015 Paris (FR)
(72) Inventeur: CLARET, Thierry, 38054 GRENOBLE CEDEX 09 (FR); FERREIRA, Delphine, 38054 GRENOBLE CEDEX 09 (FR); LEFEVRE, Aude, 38054 GRENOBLE CEDEX 09 (FR)
(74) Mandataire: Santarelli

(56) Documents cités:
- EP-A1- 3 680 931
- EP-A1- 3 723 148
- WO-A1-2020/162459
- KR-A- 20080 018 702
- US-A1- 2015 200 058
- DUSAN LOSIC ET AL: "Porous Alumina with Shaped Pore Geometries and Complex Pore Architectures Fabricated by Cyclic Anodization", SMALL, vol. 5, no. 12, 19 June 2009 (2009-06-19), pages 1392 - 1397, XP055003997, ISSN: 1613-6810, DOI: 10.1002/smll.200801645
- HOURDAKIS E ET AL: "High-Density MIM Capacitors With Porous Anodic Alumina Dielectric", IEEE TRANSACTIONS ON ELECTRON DEVICES, IEEE, USA, vol. 30, no. 10, 1 October 2010 (2010-10-01), pages 2679 - 2683, XP011316023, ISSN: 0018-9383
- PARAG BANERJEE ET AL: "Nanotubular metal-insulator-metal capacitor arraysfor energy storage", NATURE NANOTECHNOLOGY, NATURE PUB. GROUP, INC, LONDON, vol. 4, no. 5, 1 January 2009 (2009-01-01), pages 292 - 296, XP009144550, ISSN: 1748-3387

## Description

### DOMAINE TECHNIQUE

La présente invention se rapporte au domaine général des dispositifs capacitifs.

L'invention concerne un procédé de fabrication d'un dispositif capacitif à haute densité.

L'invention concerne également un dispositif capacitif ainsi obtenu.

L'invention est particulièrement intéressante puisqu'elle permet d'obtenir un dispositif capacitif à haute densité (plus de 1µF/mm²) présentant une bonne compacité.

L'invention trouve des applications dans de nombreux domaines industriels, et notamment pour la fabrication de composants passifs et pour l'intégration 3D.

### ÉTAT DE LA TECHNIQUE ANTÉRIEURE

Les capacités à haute densité font aujourd'hui l'objet d'intenses développements. Ces capacités comprennent notamment un empilement, dit empilement capacitif, pourvu de deux ou trois couches, et formé sur une surface ou une structure présentant un facteur de forme élevé afin de limiter l'encombrement de ces capacités.

À cet égard, les nanofils ou les nanotubes, et plus particulièrement les nanotubes de carbone (NTC), qui présentent un rapport surface/volume important, sont des candidats de choix pour la réalisation de ces structures à facteur de forme élevé. Pour former de telles capacités, un empilement Métal/Isolant/Métal (ou un empilement Isolant/Métal) est déposé sur la surface déployée des piliers de NTC ou des nanofils. Puis des zones capacitives avec la MIM (ou IM) et des zones de reprise de contact sur l'électrode inférieure sont définies. Cette technologie à base de NTC ou des nanofils permet la reprise de contact pour des composants RF (> GHz). Cependant, la maturité de cette technologie reste encore à démontrer.

Parmi les dispositifs capacitifs les plus aboutis, on peut citer ceux obtenus avec un dépôt Métal/Isolant/Métal (MIM) sur la surface déployée d'une matrice d'alumine poreuse. Des capacités à haute densité (de l'ordre de 1µF/mm²) avec des tensions de claquage de quelques volts peuvent être obtenues. Ces dispositifs commencent à alimenter les marchés. EP 3 723 148 A1 divulgue un procédé de fabrication d'un tel dispositif capacitif.

L'alumine poreuse est obtenue par anodisation d'une couche d'aluminium à travers un masque dur comprenant des ouvertures au niveau de la zone capacitive et de la zone de reprise de contact.

Or, lors de l'anodisation de l'aluminium, le masque dur subit de fortes déformations à cause du foisonnement du matériau anodisé (typiquement, le coefficient de foisonnement est compris entre 1,2 et 1,6). Cette déformation génère une topologie de quelques microns mais surtout des fissures dans le masque dur. Afin de colmater les fissures, une couche « d'étanchéité » est généralement formée au-dessus du masque.

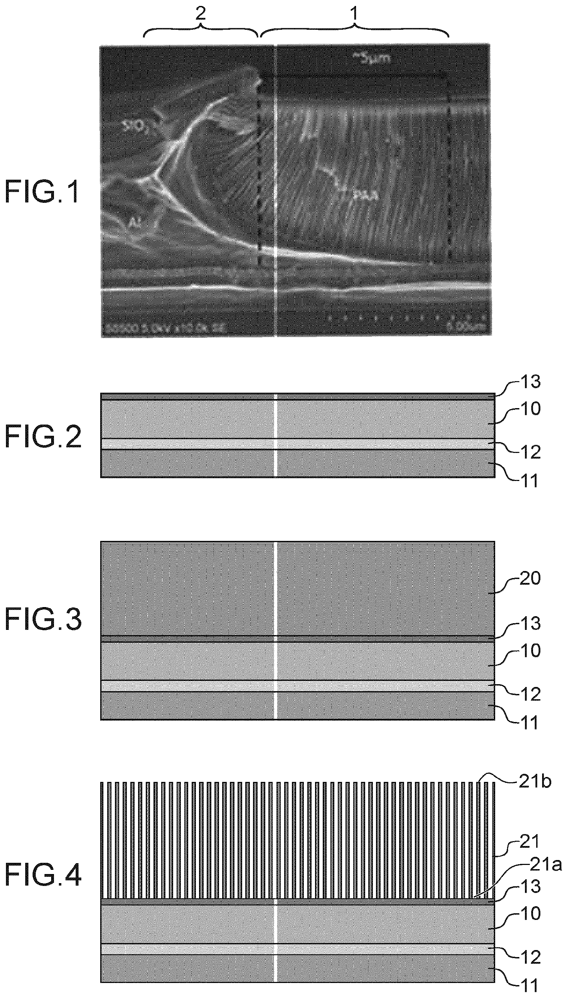

Cependant, un tel procédé engendre une zone périphérique inexploitable comprenant (figure 1) :
- une première partie 1 avec des pores accessibles mais disposés de manière non verticale,
- une seconde partie 2 avec des pores inhomogènes disposés sous le masque dur et/ou sous la couche de protection assurant l'étanchéité du masque dur.

Ainsi, la mise en œuvre d'un masque dur, non seulement, complexifie le procédé mais détériore, également, une partie de la surface disponible en une zone inexploitable.

### EXPOSÉ DE L'INVENTION

Un but de la présente invention est de proposer un procédé remédiant aux inconvénients de l'art antérieur et permettant d'obtenir un dispositif capacitif à haute densité, le procédé devant être simple à mettre en œuvre.

Pour cela, la présente invention propose un procédé de fabrication d'un dispositif capacitif comprenant les étapes suivantes :
a) fournir une couche métallique,
b) déposer une couche d'aluminium pleine plaque,
c) structurer des pores dans la couche d'aluminium par un procédé de gravure anodique pleine plaque, moyennant quoi on obtient une couche d'alumine poreuse continue comprenant une première face principale et une deuxième face principale, des pores longitudinaux allant de la première face principale à la deuxième face principale de la couche d'alumine, les pores étant perpendiculaires ou sensiblement perpendiculaires à la première face principale et à la deuxième face principale,
d) former une zone capacitive au niveau d'une première zone de la couche d'alumine poreuse,
e) former une électrode supérieure sur la zone capacitive,
f) former une reprise de contact au niveau d'une deuxième zone de la couche d'alumine poreuse,
g) former une électrode inférieure sur la reprise de contact.

L'invention se distingue fondamentalement de l'art antérieur par la formation d'une matrice isolante d'alumine poreuse pleine plaque. Un tel procédé ne nécessite pas de masque.

Le procédé de fabrication du dispositif capacitif est également simplifié par rapport à ceux de l'art antérieur et permet de préserver l'intégrité des pores de la matrice d'alumine.

Selon une première variante de réalisation, l'étape d) et/ou l'étape f) peuvent être réalisées en déposant un empilement capacitif dans les pores de la couche d'alumine poreuse.

Selon cette première variante de réalisation, l'étape d) du procédé peut comprendre les sous-étapes suivantes :
d1) sur la couche d'alumine poreuse former un masque ayant une ouverture rendant accessible la première zone de la couche d'alumine poreuse,
d2) déposer un premier empilement capacitif continu sur la première zone de la couche d'alumine poreuse, le premier empilement capacitif recouvrant de manière conforme la couche d'alumine poreuse et tapissant de manière conforme les pores de la couche d'alumine poreuse, au niveau de la première zone,
le premier empilement capacitif comprenant une couche conductrice supérieure, une couche isolante et une couche conductrice inférieure.

Selon cette première variante de réalisation, l'étape f) du procédé peut comprendre les sous-étapes suivantes :
f1) sur la couche d'alumine poreuse former un masque ayant une ouverture rendant accessible la deuxième zone de la couche d'alumine poreuse,
f2) déposer un deuxième empilement capacitif continu sur la deuxième zone de la couche d'alumine poreuse, le deuxième empilement capacitif recouvrant de manière conforme la couche d'alumine poreuse et tapissant de manière conforme les pores de la couche d'alumine poreuse, au niveau de la deuxième zone,
f3) graver le deuxième empilement capacitif au niveau de la deuxième zone de la couche d'alumine poreuse de manière à rendre accessible la seconde face de la couche d'alumine poreuse au niveau de la deuxième zone,
le deuxième empilement capacitif comprenant une couche conductrice supérieure, une couche isolante et une couche conductrice inférieure.

Avantageusement, les étapes d1) et f1) sont réalisées simultanément et/ou les étapes d2) et f2) sont réalisées simultanément.

Avantageusement, le premier empilement capacitif et le deuxième empilement capacitif sont identiques et déposés simultanément par ALD.

Selon une autre variante de réalisation, l'étape d) et/ou l'étape f) peuvent être réalisées en formant des nanofils métalliques dans les pores de la couche d'alumine poreuse au niveau de la première zone et/ou au niveau de la deuxième zone, en retirant la couche d'alumine poreuse puis en déposant un empilement capacitif sur les nanofils métalliques.

Selon cette deuxième variante de réalisation, l'étape d) du procédé peut comprendre les sous-étapes suivantes :
d1') sur la couche d'alumine poreuse former un masque ayant une ouverture rendant accessible la première zone de la couche d'alumine poreuse,
d2') former des nanofils métalliques ou nanotubes de carbone dans les pores de la couche d'alumine poreuse au niveau de la première zone par électrochimie,
d3') retirer la couche d'alumine poreuse au niveau de la première zone,
d4') déposer un empilement capacitif continu sur les nanofils métalliques ou sur les nanotubes de carbone au niveau de la première zone, l'empilement capacitif recouvrant de manière conforme les nanofils métalliques ou les nanotubes de carbone,
l'empilement capacitif comprenant une couche conductrice supérieure, une couche isolante et éventuellement une couche conductrice inférieure.

Selon cette deuxième variante de réalisation, l'étape f) du procédé peut comprendre les sous-étapes suivantes :
f1') sur la couche d'alumine poreuse former un masque ayant une ouverture rendant accessible la deuxième zone de la couche d'alumine poreuse,
f2') former des nanofils métalliques ou nanotubes de carbone dans les pores de la couche d'alumine poreuse au niveau de la deuxième zone par électrochimie,
f3') retirer la couche d'alumine poreuse au niveau de la deuxième zone,
f4') déposer un empilement capacitif continu sur les nanofils métalliques ou sur les nanotubes de carbone, au niveau de la deuxième zone, l'empilement capacitif recouvrant de manière conforme les nanofils métalliques ou les nanotubes de carbone,
l'empilement capacitif comprenant une couche conductrice supérieure, une couche isolante et éventuellement une couche conductrice inférieure.

Il est possible de réaliser :
- la zone capacitive et la reprise de contact selon la première variante de réalisation,
- la zone capacitive et la reprise de contact selon la deuxième variante de réalisation,
- la zone capacitive selon la première variante de réalisation et la reprise de contact selon la deuxième variante de réalisation,
- la zone capacitive selon la deuxième variante de réalisation et la reprise de contact selon la première variante de réalisation.

Alternativement, la reprise de contact (étape f) peut être formée selon les sous-étapes suivantes :
- sur la couche d'alumine poreuse, former un masque ayant une ouverture rendant accessible la deuxième zone de la couche d'alumine poreuse,
- remplir totalement ou partiellement les pores de la couche d'alumine poreuse au niveau de la deuxième zone, avec un élément électriquement conducteur (comme du cuivre, du tungstène ou du nickel), de préférence par dépôt électrochimique ou par dépôt de couches atomiques, de manière à former une reprise de contact.

Avantageusement, la couche métallique repose sur un substrat support recouvert d'une couche diélectrique et le procédé comporte une étape au cours de laquelle on forme, par exemple par gravure humide, une tranchée dans la couche d'alumine poreuse, la tranchée allant jusqu'à la couche d'oxyde recouvrant le substrat support.

Avantageusement, une couche barrière, de préférence en tungstène, est disposée entre la couche métallique et la couche d'aluminium.

En fonction des spécifications des capacités, la couche d'alumine poreuse peut avoir une épaisseur de quelques micromètres à quelques dizaines de micromètres. Avantageusement, la couche d'alumine poreuse a une épaisseur allant de 10 à 15µm.

Le procédé présente de nombreux avantages :
- la couche d'alumine poreuse est obtenue pleine plaque, sans utiliser de masque, ce qui simplifie le procédé de fabrication, et réduit les coûts de fabrication,
- l'anodisation pleine plaque évite la détérioration des pores comme c'est le cas avec les procédés de l'art antérieur,
- la topologie est maitrisée,
- une optimisation de l'implantation,
- permettre une reprise de contact idéale pour des dispositifs RF,
- une simplification de l'empilement,
- une facilité de procédé pour isoler l'électrode inférieure malgré la forte topologie et/ou une facilité de procédé pour générer des chemins de découpe malgré la forte topologie par une gravure locale de la couche d'alumine qui se fait à partir des pores, de manière latérale, en une dizaine de minutes ; la durée de cette gravure est indépendante de la hauteur des pores.

L'invention concerne également un dispositif capacitif à haute densité, obtenu selon le procédé précédemment décrit, comprenant :
- une couche métallique, de préférence à base d'aluminium, par exemple en AlCu,
- une couche d'alumine poreuse continue comprenant une première face principale et une seconde face principale, la couche d'alumine poreuse comprenant des pores traversant allant de la première face principale à la deuxième face principale, les pores étant perpendiculaires ou sensiblement perpendiculaires à la première face principale et à la deuxième face principale,
- un premier empilement capacitif continu recouvrant de manière conforme la seconde face de la couche d'alumine poreuse et tapissant de manière conforme les pores de la couche d'alumine poreuse au niveau d'une première zone de la couche d'alumine poreuse, de manière à former une zone capacitive, le premier empilement capacitif comprenant une couche conductrice supérieure, par exemple en TiN, une couche isolante par exemple en Al₂O₃, et éventuellement une couche conductrice inférieure par exemple en TiN.
- une électrode supérieure recouvrant la zone capacitive,
- un élément électriquement conducteur remplissant partiellement ou totalement les pores de la couche d'alumine poreuse au niveau d'une deuxième zone, et laissant accessible la seconde face principale de la couche d'alumine poreuse au niveau de la deuxième zone, de manière à former une reprise de contact, l'élément électriquement conducteur étant de préférence, un deuxième empilement capacitif continu tapissant de manière conforme les pores de la couche d'alumine poreuse au niveau de la deuxième zone de la couche d'alumine poreuse, le deuxième empilement, étant avantageusement identique au premier empilement capacitif,
- une électrode inférieure recouvrant la reprise de contact.

Ainsi, la structure capacitive obtenue comporte :
- une couche métallique, reliée électriquement à l'électrode inférieure,
- une matrice d'alumine poreuse, ayant un fort facteur forme, disposée sur la couche métallique,
- une zone capacitive, formée d'une première zone (ou partie) de la matrice d'alumine poreuse et par un empilement capacitif, de préférence un tri-couche métal, isolant, métal (MIM), tapissant les pores de la matrice poreuse,
- une zone de reprise de contact BF et/ou RF disposée au niveau d'une deuxième zone (ou partie) de la matrice d'alumine poreuse, et formée grâce à un dépôt de matériau conducteur, le dépôt pouvant éventuellement remplir complètement la matrice poreuse.

L'invention se distingue fondamentalement de l'art antérieur par la présence d'une couche d'alumine poreuse formée pleine plaque.

Le dispositif capacitif présente d'une part, une topologie plus maitrisée, et surtout une implantation optimisée, et d'autre part, une reprise de contact de l'électrode inférieure permettant d'envisager des composants RF fonctionnant au-delà du GHz.

La configuration et/ou l'agencement d'un tel dispositif capacitif permet de conférer à ce dernier une meilleure compacité au regard des dispositifs connus de l'état de la technique.

Le dépôt d'un empilement MIM (métal/isolant/métal) ou IM (isolant/métal) remplissant partiellement ou de préférence totalement les pores de l'alumine permet d'optimiser des contacts RF plus performants qu'un matériau plein de section équivalente, les courants RF n'étant que des « courants de peau ».

Avantageusement, le dispositif comprend une zone d'isolement formée d'une tranchée dans la couche d'alumine poreuse, la tranchée allant jusqu'à la couche diélectrique recouvrant le substrat support.

Le dispositif présente de nombreux avantages :
- toute la zone capacité peut être utilisée, contrairement aux capacités de l'art antérieur qui présentent une partie « inutile »,
- le matériau poreux est, avantageusement, utilisé pour créer un via pour connecter l'électrode inférieure,
- la section des courants de peaux, et donc la conduction en RF pour des marchés actuels avec des fréquences qui augmentent (de l'ordre du GigaHertz),
- il n'y a pas besoin de gravure ni de dépôt de matière sur de fortes hauteurs (plusieurs dizaine de µm) et l'utilisation d'un dépôt de type ALD permet d'obtenir une couche mince et de maximiser la capacité,
- la zone de séparation permet une isolation de l'électrode inférieure de chaque dispositif et/ou la formation de chemins de découpe,
- l'optimisation de l'implantation des capacités haute densité, zones de reprise de contact incluses.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1 précédemment décrite, représente une vue transversale d'une structure à base d'alumine poreuse obtenue avec un masque dur d'anodisation, selon l'art antérieur,
Les figures 2 à 11 représentent de manière schématique différentes étapes d'un procédé de fabrication d'un dispositif capacitif selon un mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », « sur », «dessous », « sous », etc. d'une structure s'appliquent en considérant que la structure est orientée de la façon illustrée sur les figures.

### EXPOSÉ DÉTAILLÉ DE MODES DE RÉALISATION PARTICULIERS

Bien que cela ne soit aucunement limitatif, l'invention trouve particulièrement des applications dans le domaine des capacités haute densité de plus de 1µF/mm². Le dispositif capacitif pourra avantageusement être intégré dans une structure comprenant d'autres composants.

Nous allons maintenant décrire plus en détail un procédé de fabrication d'un dispositif capacitif selon un mode de réalisation particulier de l'invention en se référant aux figures 2 à 11.

Le principe du procédé de l'invention consiste à générer des couches d'alumine poreuse « pleine plaque ».

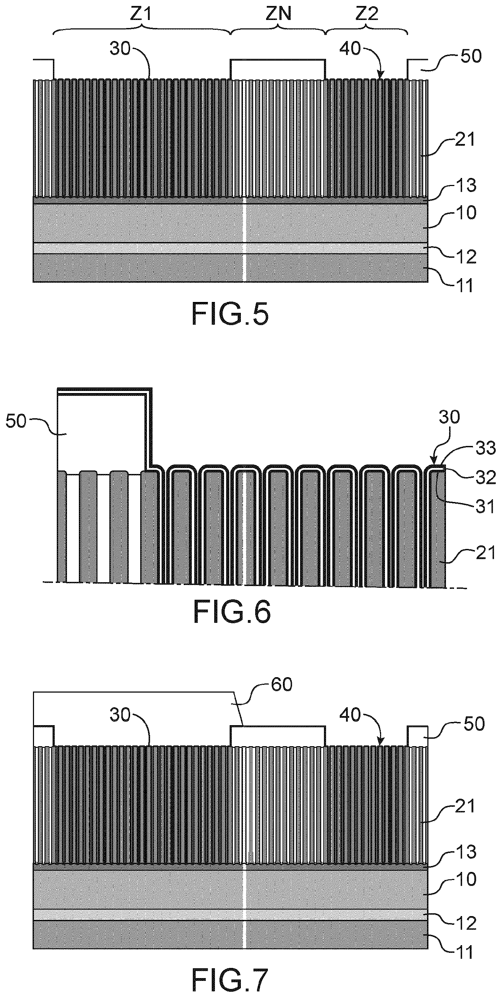

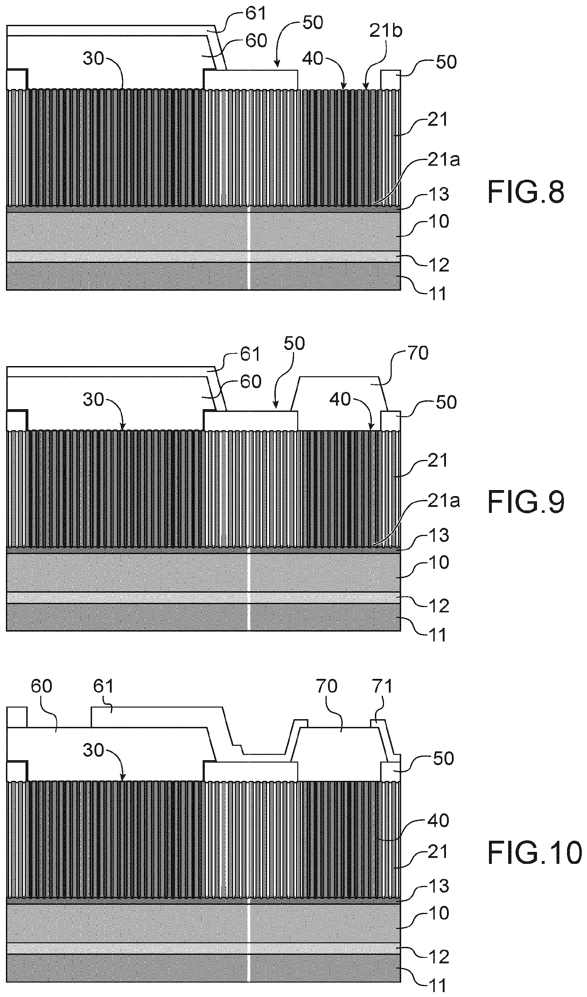

Le procédé comprend les étapes suivantes :
- fabrication d'un substrat de base («base wafer ») à travers les étapes a), b) et c) suivantes :
   a) fournir une couche métallique 10 (figure 2),
   b) déposer une couche d'aluminium 20 pleine plaque (figure 3),
   c) structurer des pores dans la couche d'aluminium 20 par un procédé de gravure anodique pleine plaque, moyennant quoi on obtient une couche d'alumine poreuse continue 21 comprenant une première face principale 21a et une deuxième face principale 21b, des pores longitudinaux allant de la première face principale 21a à la deuxième face principale 21b de la couche d'alumine poreuse 21 (figure 4),
- personnalisation du substrat de base à travers les étapes d), e), f) et g) suivantes :
   d) former une zone capacitive au niveau d'une première zone Z1 (aussi appelée zone capacitive) de la couche d'alumine poreuse 21 (figures 5 et 6),
   e) former une électrode supérieure 60 sur la première zone Z1 de la couche d'alumine poreuse 21 (figure 7),
   f) former une zone de reprise de contact au niveau d'une deuxième zone Z2 (aussi appelée zone de reprise de contact) de la couche d'alumine poreuse (figure 5),
   g) former une électrode inférieure 70 sur la zone de reprise de contact (figure 9).

La couche métallique 10 fournie à l'étape a) comprend une face avant et une face arrière opposée et essentiellement parallèle à la face avant. La couche métallique 10 est de préférence à base d'aluminium. La couche métallique 10 peut comprendre de l'aluminium et/ou du cuivre. La couche métallique 10 peut présenter une épaisseur comprise entre 0,5 µm et 3 µm.

Avantageusement, comme représenté sur les figures 2 à 11, la couche métallique 10 repose sur un substrat support 11, de préférence recouvert par une couche diélectrique 12, notamment une couche d'oxyde. La couche diélectrique 12 est ainsi intercalée entre le substrat support 11 et la couche métallique 10.

Le substrat support 11 est notamment un substrat de silicium.

La couche diélectrique 12 est, par exemple, une couche d'oxyde de silicium.

La couche métallique 10 peut être formée sur la couche diélectrique par une technique de dépôt ou d'évaporation.

De manière encore plus avantageuse, une couche dite barrière à l'anodisation 13 recouvre la couche métallique 10. De la sorte, la couche barrière de gravure 13 vient protéger la couche métallique 10 lors de la formation des pores de l'alumine (étape c). Par exemple, la couche barrière 13 est une couche de tungstène. Selon une autre variante de réalisation, la couche barrière 13 comprend un empilement. Par exemple, la couche barrière 13 peut comprendre une couche de tungstène pleine plaque, par exemple de 300 nm d'épaisseur.

La couche barrière de gravure 13 peut être par exemple déposée par dépôt en phase vapeur (ou PVD pour « Physical Vapor Deposition ») ou par dépôt de couches atomiques (ALD pour « Atomic Layer Depostion »).

Lors de l'étape b), on dépose une couche d'aluminium 20 pleine plaque (figure 3). L'épaisseur de la couche d'alumine poreuse 21 finale dépend de l'épaisseur de de la couche d'aluminium 20 initiale.

Lors de l'étape c), on anodise et on grave la couche d'aluminium 20, de manière à former de la couche d'alumine 21 (figure 4).

L'anodisation est un procédé électrolytique se déroulant en milieu humide. Le principe repose sur l'application d'une différence de potentiel imposée entre deux électrodes conductrices plongées dans une solution électrolytique qui peut par exemple être acide oxalique ou phosphorique. L'application d'un potentiel à l'anode, induit une croissance d'alumine à sa surface, si l'électrode est en aluminium, et qui lors de sa dissolution dans le bain d'acide provoque l'apparition de nano-pores ou de trous dans la surface du métal.

Avantageusement, grâce au procédé d'anodisation aucune étape de photolithographie n'est utilisée pour créer les pores. Cette étape est réalisée pleine plaque. Il n'y a pas besoin de masque.

Ce procédé permet ainsi d'optimiser le procédé de fabrication d'une telle structure.

La gravure est réalisée jusqu'à former des pores débouchant sur la couche conductrice métallique 10 ou sur la couche barrière 13, le cas échéant.

L'étape c) peut être mise en œuvre dans un bain d'acide, et notamment dans un bain comprenant un ou plusieurs acides comme l'acide oxalique ou l'acide phosphorique, ou d'autres acides faibles.

Au cours de cette étape c), la couche d'aluminium 20 est structurée par oxydation et gravure.

Lors de l'oxydation, il se forme de l'oxyde d'aluminium (alumine ou Al₂O₃).

Les nano-pores ont avantageusement un diamètre de l'ordre de 50 nm avec un pas de l'ordre de 150 nm. Le diamètre des nano-pores peut éventuellement être agrandi à un diamètre de l'ordre de 80 nm par gravure humide dans un bain d'acide, acide phosphorique par exemple.

De plus, le procédé d'anodisation utilisé dans la présente invention permet l'obtention de nano-pores débouchant sur la couche métallique 10 ou sur la barrière de gravure 13 le cas échéant. Cette caractéristique est obtenue par une courte sur-gravure humide de la couche anodisée dans une solution fonction de la nature de la couche barrière. On choisira, généralement, des solutions d'acide faible tamponnées. En d'autres termes, les nanopores peuvent être considérés comme des nano-cylindres dont un côté débouche sur la couche barrière de gravure.

La couche d'alumine poreuse 21 ainsi obtenue comprend une première face principale 21a et une deuxième face principale 21b. Les pores de la couche d'alumine poreuse 21 s'étendent entre la première face principale 21a et la deuxième face principale 21b. Les pores débouchent sur chacune de ces faces. Chaque pore forme un canal longitudinal perpendiculaire ou sensiblement perpendiculaire aux faces principales 21a, 21b de la couche d'alumine poreuse 21.

La couche d'alumine 21 forme une matrice poreuse.

La couche d'alumine 21 a une épaisseur allant de quelques micromètres à quelques dizaines de micromètres, par exemple de 10 µm à 15µm.

Les étapes d) à g) consistent à générer une zone capacitive, une zone de contact inférieure et éventuellement une zone neutre sur la couche d'alumine poreuse.

Les étapes décrites précédemment finalisent la fabrication de substrats « pleine plaque » avant une personnalisation spécifique pour réaliser un ou des composants donnés. Cette disposition permet d'optimiser la fabrication de ces substrats « standardisés » et de réduire les coûts associés.

Les étapes ci-après décrivent la personnalisation de ces substrats pour des dispositifs spécifiques.

Selon une première variante de réalisation, la zone capacitive et/ou la zone de reprise de contact peuvent être formées en déposant un empilement capacitif dans les pores de la matrice.

Plus particulièrement, un procédé avantageux de fabrication d'un dispositif capacitif selon cette première variante comprend les étapes successives suivantes :
i) réaliser les étapes a) à c) précédemment décrites
ii) réaliser l'étape d) et l'étape f) de préférence simultanément en formant, avantageusement, un seul masque 50 sur la couche d'alumine poreuse 21, le masque 50 ayant des ouvertures au niveau d'une première zone Z1 de la couche d'alumine poreuse 21 et au niveau d'une deuxième zone Z2 de la couche d'alumine poreuse 21, puis en déposant simultanément un empilement capacitif continu sur la première zone Z1 de la couche d'alumine poreuse 21 et sur la deuxième zone Z2 de la couche d'alumine poreuse 21, l'empilement capacitif 30 recouvrant de manière conforme la première zone Z1 de la couche d'alumine poreuse 21 et la deuxième zone Z2 de la couche d'alumine poreuse 21, et tapissant de manière conforme les pores de la première zone Z1 de la couche d'alumine poreuse et de la deuxième zone Z2 de la couche d'alumine poreuse (figures 5 et 6),
   l'empilement capacitif 30 comprenant une couche conductrice supérieure 33, une couche isolante 32 et une couche conductrice inférieure 31,
iii) réaliser l'étape e) (i.e. former une électrode supérieure 60 sur la première zone) - figure 7, puis graver la couche supérieure du dispositif capacitif (10 nm de TiN) à travers le masque dur de la couche conductrice 60,
iv) déposer une couche de protection 61 sur l'électrode supérieure 60,
v) graver l'empilement capacitif 30 au niveau de la deuxième zone Z2 de la couche d'alumine poreuse 21 de manière à rendre accessible la seconde face 21b de la couche d'alumine poreuse 21 au niveau de la deuxième zone Z2 (figure 8),
vi) réaliser l'étape g) (i.e. former une électrode inférieure 70 sur la deuxième zone) - figure 9).

Le masque 50 permet, avantageusement, de protéger la zone neutre lors du dépôt de l'empilement capacitif. Il peut être fabriqué selon les sous-étapes suivantes :
- une sous-étape de dépôt d'une première couche diélectrique, par exemple une couche d'oxyde de silicium,
   - une sous-étape de dépôt d'une deuxième couche diélectrique, par exemple une couche de nitrure de silicium, de manière à former un empilement diélectrique,
   - une sous-étape de photolithographie/gravure destinée à conserver l'empilement exclusivement au niveau de la zone neutre ZN.

Les première et deuxième couches peuvent par exemple présenter une épaisseur comprise entre 10 nm et 1000 nm.

La première couche diélectrique peut comprendre du TEOS et présenter une épaisseur comprise entre 100 et 1000 nm, par exemple égale à 500 nm.

La deuxième couche diélectrique, formée en recouvrement de la première couche diélectrique, peut présenter une épaisseur comprise entre 100 nm et 500 nm.

Lors de la sous-étape de photolithographie/gravure, on définit un premier motif et un deuxième motif dans la deuxième couche diélectrique de sorte que cette dernière forme un masque dur. Il est entendu que le premier motif et le deuxième motif forment des ouvertures traversantes dans la deuxième couche diélectrique. Ce premier motif et ce deuxième motif permettent en particulier de délimiter la zone capacitive et la zone de reprise de contact respectivement.

La formation des motifs peut faire intervenir des étapes de photolithographie, de gravure et de retrait de résine photosensible (« stripping » selon la terminologie Anglo-Saxonne).

La gravure est, notamment une gravure sèche, destinée à graver la première couche diélectrique à travers le masque dur formé par la deuxième couche diélectrique, de manière à former une première ouverture, conforme au premier motif, et une deuxième ouverture conforme au deuxième motif.

Alternativement, si l'ouverture des pores n'a pas été réalisée complètement lors de l'étape c), il est possible de le faire après la formation du masque 50 et avant le dépôt de l'empilement capacitif.

On réalise le dépôt d'un empilement Métal/Isolant/Métal (MIM) ou d'un empilement Isolant/Métal (IM) en profitant de la surface déployée de l'alumine poreuse.

L'empilement capacitif continu 30 comprend une couche conductrice supérieure 33 et une couche isolante 32 isolant la couche conductrice supérieure 33 de la couche d'alumine poreuse 21.

L'empilement capacitif comprend, en outre, une couche conductrice inférieure 31. De préférence, l'empilement capacitif 30 comprend deux couches conductrices 31, 33 séparées par une couche isolante 32.

Le remplissage simultané des pores de la zone de reprise de contact et de la zone capacitive permet de limiter le nombre d'étapes du procédé. Le dépôt de la MIM ou IM peut être réalisé par dépôts successifs par une technique de dépôt en couches atomique (ALD). Cette technique de dépôt, particulièrement conforme, permet de déposer l'empilement sur la deuxième face de la matrice poreuse, mais aussi dans les pores de la matrice poreuse jusqu'à contacter la couche métallique 10 ou la barrière de gravure 13, le cas échéant, accessible au fond des pores.

Pour former l'empilement capacitif, on forme la couche conductrice inférieure 31, la couche isolante 32 puis la couche conductrice supérieure 33.

La première couche conductrice 31 vient en contact avec la couche métallique 10 ou la couche barrière de gravure 13 située tout au fond des nano-pores. Cette première couche conductrice 31 peut être réalisée à l'aide par exemple d'une technique de dépôt de type ALD. Les matériaux utilisés peuvent être, par exemple, du TiN, du TaN, du NiB, du Ru ou tout autre matériau conducteur.

La couche isolante 32 de l'empilement capacitif 30, permet de créer la capacité entre la couche conductrice supérieure 33 et la couche conductrice inférieure 31. Le matériau utilisé pour réaliser cette couche diélectrique doit avoir une permittivité électrique k la plus élevée possible afin de maximiser la valeur de capacité réalisée. Plusieurs types de matériaux dit matériaux «High-k» préférentiellement avec une permittivité électrique (k>6) peuvent être utilisés, comme par exemple, le nitrure de silicium (Si₃N₄), alumine (oxyde d'aluminium), l'oxyde de hafnium (HfO₂), ou tout autre matériau ayant une permittivité électrique k supérieure ou égale aux matériaux cités précédemment. De plus, les matériaux utilisés doivent être compatibles avec les procédés technologiques utilisés pour la fabrication de la structure à capacité de type MIM.

L'épaisseur de la couche isolante 32 est comprise par exemple entre 5 nm et 80 nm (1 nm = 10⁻⁹ m), préférentiellement elle peut être d'une épaisseur de l'ordre de 10nm.

Les procédés de dépôt permettant d'obtenir la couche isolante 32 peuvent utiliser différentes techniques connues de l'homme de l'art. À titre d'exemple, le dépôt par couche atomique (en Anglais «Atomic Layer Depostion » ou ALD), ou le dépôt chimique en phase vapeur à basse pression (en Anglais «Low Pressure Chemical Vapor Deposit » ou LPCVD) peuvent être préférentiellement utilisées.

La seconde couche conductrice 33 de l'empilement capacitif 30 est ensuite déposée sur la couche diélectrique 32 permettant ainsi de créer la capacité de type MIM. Les caractéristiques de cette seconde couche conductrice ainsi que les méthodes de dépôt peuvent être identiques à celles utilisées pour la réalisation de la première couche conductrice.

La couche conductrice inférieure 31 peut être en nitrure de titane.

La couche conductrice supérieure 33 peut être en nitrure de titane.

La couche isolante 32 peut être en alumine.

De préférence, l'empilement capacitif 30 est un tricouche TiN/Al₂O₃/TiN.

La deuxième couche diélectrique du masque 50 qui n'est pas protégée lors de ce dépôt est également recouverte par l'empilement capacitif 30.

A contrario, dans la zone neutre ZN, la fraction protégée par le masque 50 (i.e. par les deux couches diélectriques) est exempte d'empilement capacitif.

Cet agencement permet de prendre des contacts électriques sans exposer les pores de la matrice à des étapes de procédé susceptibles de les endommager.

L'électrode supérieure 60 formée lors de l'étape e) est obtenue en déposant une couche de métal. L'électrode supérieure 60 a une épaisseur, par exemple de l'ordre de 1µm à 5 µm. Les matériaux utilisés pour l'électrode supérieure peuvent être par exemple de l'aluminium (AI), du cuivre (Cu), de l'argent (Ag) combinés ou non avec des métaux barrières comme par exemple le nitrure de titane (TiN), ou le nitrure de tantale (TaN). Par exemple, il peut s'agir d'un alliage AlCu.

L'électrode supérieure 60 peut présenter un léger recouvrement avec les couches diélectriques de la zone neutre ZN. La formation de l'électrode supérieure 60 est connue de l'homme du métier et n'est donc pas décrite plus en détails.

Le dispositif peut comprendre une électrode supérieure 60 en recouvrement de la première partie de la matrice poreuse (zone capacitive) et agencée de manière à contacter électriquement la couche conductrice supérieure 33 de l'empilement capacitif 30. L'électrode supérieure 60 peut être recouverte d'une ou plusieurs couches de matériau isolant. Une reprise de contact en la forme d'un plot métallique (« UBM » ou « Upper Bump Metallurgy » selon la terminologie anglo-saxonne) peut être formée au travers de la couche ou des couches en matériaux isolants. Il peut s'agir d'une couche d'oxyde de silicium, une couche de nitrure de silicium ou d'un bicouche comprenant les deux couches précitées.

L'étape iv) consiste à protéger l'électrode supérieure 60 en vue de l'étape v) destinée à exposer à l'environnement extérieur la zone de contact inférieur Z2. L'étape g) consiste par exemple à former une couche diélectrique 61 en recouvrement de l'électrode supérieure.

L'étape v) est une étape de gravure, notamment de gravure RIE à travers le masque dur Al₂O₃/SiN pour graver la partie de l'empilement capacitif 30 qui dépasse de la deuxième face principale 21b de la couche d'alumine poreuse 21 au niveau de la deuxième zone (zone Z2 ou ZCI).

La gravure est conforme au deuxième motif, et ainsi permet d'exposer à l'environnement extérieur la zone de contact inférieur ZCI.

L'étape v) est alors suivie de la formation d'une électrode inférieure 70 (étape vi) selon un protocole similaire à celui employé pour la formation de l'électrode supérieure (étape iii). L'électrode inférieure 70 peut être en un matériau identique ou différent de celui de l'électrode supérieure. L'électrode inférieure 70 est par exemple en AlCu.

Le dispositif peut comprendre une électrode inférieure 70 en recouvrement de la deuxième zone Z2 de la matrice poreuse 21 (zone de contact inférieur) et agencée de manière à contacter électriquement la deuxième face principale 21b de la matrice poreuse 21 au niveau de la zone de contact inférieur.

L'électrode inférieure 70 peut être recouverte par une couche de matériau isolant 71. Une reprise de contact en la forme d'un plot métallique (« UBM ») peut être formée à travers cette couche.

Un ou plusieurs plots de contact peuvent être formés au niveau de l'électrode supérieure et/ou de l'électrode inférieure (figure 10).

Enfin, le procédé de fabrication du dispositif capacitif peut se terminer par la formation d'une couche de passivation et de l'ouverture de cette dernière en deux points de contact de manière à accéder électriquement à l'électrode supérieure et à l'électrode inférieure.

Les points de contact sont notamment des plots métalliques (« UBM »).

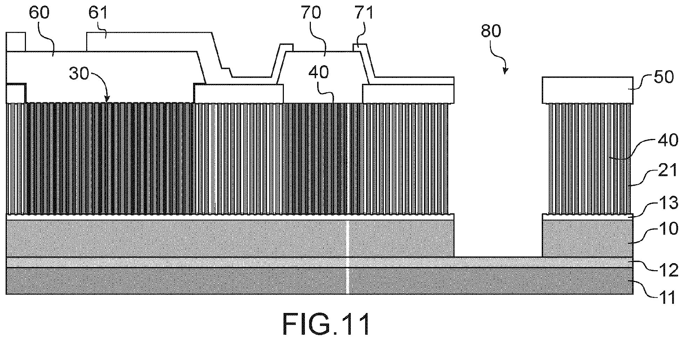

Le procédé peut également comporter une étape au cours de laquelle on forme une tranchée 80 (figure 11). La tranchée 80 forme une zone de séparation des dispositifs. Cette tranchée 80 peut servir, par exemple, à former des chemins de découpe ou pour dissocier l'électrode inférieure.

La tranchée 80 servant à isoler l'électrode inférieure 70 du dispositif adjacent peut être réalisée jusqu'à la couche métallique 10, ou jusqu'à la couche diélectrique 12 recouvrant le substrat support 11 ou jusqu'à la couche barrière 13 (pouvant servir de couche d'arrêt).

La tranchée 80 peut être obtenue, par exemple par gravure humide.

La gravure humide permet notamment d'élargir latéralement les pores. La solution de gravure peut être une solution H₃PO₄ (7%) à 45°C.

La gravure de la couche d'alumine poreuse 21, de la couche barrière 13 et de la couche métallique 10 est réalisée en fonction de l'épaisseur des murs d'Al₂O₃ et non pas de la hauteur (de l'ordre de la dizaine de minutes avec une solution H₃PO₄ à 7% à 45°C).

Le dispositif capacitif ainsi obtenu est remarquable en ce qu'il comporte une couche d'alumine poreuse continue pleine plaque recouverte localement et de manière conforme par un empilement capacitif. L'empilement capacitif tapisse de manière conforme les pores de la matrice poreuse.

L'agencement de l'empilement capacitif permet de définir une zone capacitive (première zone) et une zone de contact inférieur (deuxième zone) au sein du dispositif capacitif. Notamment, la zone capacitive est une zone au niveau de laquelle l'empilement capacitif encapsule la matrice poreuse et tapisse les pores de la matrice poreuse, tandis que la zone de contact inférieur est une zone au niveau de laquelle d'une part l'empilement capacitif laisse découvert la deuxième face principale de la couche d'alumine poreuse tout en tapissant les pores de le matrice poreuse.

Le dispositif peut également comprendre une zone neutre s'interposant entre la zone capacitive et la zone de contact inférieur.

La zone neutre recouvre une troisième zone de la couche d'alumine poreuse. Avantageusement, en regard de la zone neutre, il n'y a pas d'empilement capacitif. Autrement dit, au niveau de la zone neutre, les pores de la matrice ne sont pas tapissés par l'empilement capacitif et la matrice poreuse n'est pas recouverte par l'empilement capacitif.

La zone neutre ZN peut être recouverte d'au moins une couche d'encapsulation faite de matériau isolant. La couche d'encapsulation peut notamment comprendre une couche d'oxyde de silicium ou une couche de nitrure de silicium. Il est également possible d'avoir un bicouche comprenant une couche de nitrure de silicium recouvrant la couche d'oxyde de silicium.

Alternativement, la zone de reprise de contact peut être formée en remplissant partiellement ou totalement les pores de la matrice poreuse, au niveau de la deuxième zone, avec un élément électriquement conducteur, par exemple du cuivre, du nickel, du tungstène. Cet élément électriquement conducteur peut être déposé par dépôt électrochimique (ECD) ou par dépôt de couches atomiques (ALD).

Alternativement, la zone capacitive Z1 et/ou la zone de reprise de contact Z2 peuvent être formées en formant des nanofils dans les pores de la matrice, en retirant la matrice puis en déposant un empilement capacitif dans les pores de la matrice.

Plus particulièrement, un procédé de fabrication avantageux d'un dispositif capacitif selon cette variante comprend les étapes successives suivantes :
i) réaliser les étapes a) à c) précédemment décrites
ii') réaliser l'étape d) et l'étape f) de préférence simultanément en :
   - formant un masque sur la couche d'alumine poreuse 21, le masque ayant des ouvertures au niveau d'une première zone Z1 de la couche d'alumine poreuse 21 et au niveau d'une deuxième zone Z2 de la couche d'alumine poreuse 21,
   - formant des nanofils métalliques ou des nanotubes de carbone dans les pores de la matrice au niveau de la première zone Z1 et de la deuxième zone Z2,
   - retirant la matrice d'alumine poreuse 21,
   - déposant un empilement capacitif continu sur les nanofils métalliques ou les nanotubes de carbone au niveau de la première zone poreuse et sur la deuxième zone, l'empilement capacitif recouvrant de manière conforme les nanofils métalliques ou les nanotubes de carbone,
      l'empilement capacitif comprenant une couche conductrice supérieure 33, une couche isolante 32 et éventuellement une couche conductrice inférieure 31,
iii) réaliser l'étape e) (i.e. former une électrode supérieure 60 sur la première zone Z1),
iv) déposer une couche de protection 61 sur l'électrode supérieure 60,
v) graver l'empilement capacitif au niveau de la deuxième zone Z2 de manière à rendre accessible l'extrémité des nanotubes ou des nanofils au niveau de la deuxième zone Z2,
vi) réaliser l'étape g) (i.e. former une électrode inférieure 70 sur la deuxième zone Z2).

La formation des nanofils métalliques ou des nanotubes de carbone peut être réalisée par une étape de croissance mettant en œuvre des techniques standards. En particulier, les faisceaux de nanotubes de carbone peuvent être formés par DC-PECVD ou DCVD à une température de l'ordre de 400 °C avec différents précurseurs et catalyseurs.

Les nanotubes ou les nanofils peuvent présenter une longueur moyenne comprise entre 2 µm et 40 µm, avantageusement comprise entre 2 µm et 12 µm.

Les nanofils sont, par exemple des nanofils de tungstène, cuivre ou nickel.

Les nanofils forment un réseau de nanofils.

Les nanotubes forment un réseau de nanotubes.

Les nanofils ou les nanotubes, et plus particulièrement les nanotubes de carbone, qui présentent un rapport surface/volume important, sont des candidats de choix pour la réalisation de ces structures à facteur de forme élevé.

Selon cette variante de réalisation, il est possible d'avoir un empilement capacitif de type isolant/métal (IM) ou métal/isolant/métal (MIM) car les nanofils métalliques et les nanotubes de carbone sont électriquement conducteurs.

Les étapes iii), iv) et vi) peuvent être réalisées comme pour la première variante de de réalisation.

Les couches de l'empilement capacitif peuvent être réalisées comme dans la première variante de réalisation.

### Exemples illustratifs et non limitatifs d'un mode de réalisation :

Dans cet exemple, nous allons décrire un procédé de fabrication d'un dispositif capacitif. Les natures et épaisseurs des couches conductrices ou isolantes sont données à titre indicatif.

### Fabrication du substrat de base :

1) Dépôt d'une couche de SiO₂ 12 (SiH₄) pleine plaque 500 nm sur un substrat de Silicium 11,
2) Dépôt d'une couche métallique conductrice 10, 2 µm d'AlCu pleine plaque
3) Dépôt d'une couche barrière 13 de 300 nm de W pleine plaque
4) Dépôt de 10 à 15 µm d'une couche de Al pleine plaque 20
5) Anodisation d'environ 1 µm d'Al (on pourra jouer sur la tension d'anodisation, la température du bain et l'électrolyte pour définir « l'arrangement » de l'alumine formée, en particulier l'espacement (« pitch »),
6) Gravure de l'alumine formée pour obtenir une surface d'Al préformée organisée
7) Anodisation totale de l'Al jusqu'à former des pores,
8) Eventuellement élargissement des pores par voie humide
9) Ouverture des pores jusqu'à la couche de tungstène 13.

A l'issue de ces étapes, on obtient une couche d'alumine poreuse 21 dont les pores longitudinaux vont d'une première face 21a à une deuxième face principale 21b.

### Fabrication du dispositif capacitif à partir du substrat de base :

10) Dépôt de 200 nm de SiO₂ (TEOS par exemple)
11) Structuration de la couche de SiO₂ par photolithographie puis gravure avec arrêt sur la couche d'alumine, puis retrait de la résine (« stripping, »), de manière à former un masque 50 ayant des ouvertures au niveau d'une première zone Z1 et d'une deuxième zone Z2,
12) Dépôt pleine plaque en ALD de l'empilement capacitif 30 de type « MIM », formé d'une couche conductrice inférieure 31 (par exemple 10 nm TiN), une couche isolante 32 (20 nm d'Al₂O₃ par exemple) et une couche conductrice supérieure 33

### (10 nm de TiN par exemple)

13) Dépôt d'Al ou AlCu de l'ordre de 1 µm
14) Structuration de la couche d'Al ou AlCu pour former une électrode supérieure 60 : lithographie, gravure avec arrêt sur la couche conductrice supérieure 33 en TiN de l'empilement capacitif 30 (MIM)
15) Gravure de la couche conductrice supérieure en TiN de l'empilement capacitif 30 au niveau de la seconde zone Z2 avec le masque dur Al ou masque résine et retrait de la résine (« stripping »)
16) Dépôt passivation 500 nm d'une couche de SiN 61
17) Structuration de la couche de SiN par lithographie, gravure SiN arrêt sur la couche isolante 32 en Al₂O₃ de l'empilement capacitif 30 et retrait de la résine (« stripping »)
18) Gravure RIE à travers le masque dur SiN de l'Al₂O₃ (de la MIM) avec sur-gravure de la couche conductrice inférieure 31 de l'empilement capacitif 30 (MIM) avec arrêt sur SiO₂, Alumine poreuse ou NTC ou nanofils métalliques,
19) Dépôt d'une couche en Al ou AlCu 1 µm
20) Structuration de la couche en Al ou AlCu - lithographie, gravure Al arrêt sur SiO₂ et SiN, retrait de la résine (« stripping ») pour former une électrode inférieure 70,
21) Ouverture de la couche de passivation SiN sur l'AlCu de l'électrode supérieure 60,
22) éventuellement, en fonction de la forme (« design ») des plots de contact : dépôt d'une seconde couche de passivation en SiN et ouverture de cette couche de passivation sur l'AlCu des deux électrodes 60, 70.

Dans le cas d'une incompatibilité entre l'étape de lithographie et les pores de la matrice par exemple due à une infiltration lors du retrait de la résine (ou qui pourrait être due à cause d'une mauvaise compatibilité avec les nanotubes de carbone ou les nanofils le cas échéant), les étapes 11 et 12 peuvent être remplacées par les étapes suivantes : dépôt d'une couche de SiN pour former un masque dur de SiN, puis gravure RIE du SiO₂ à travers le masque dur de SiN ; le masque dur évite que la matrice poreuse soit en contact avec une solution liquide qui pourrait polluer la structure

Afin d'éviter l'utilisation d'un masque dur, l'étape 16) peut être remplacée par les étapes suivantes :
- lithographie pour réaliser le contact de l'électrode inférieure (ouverture dans les zones de reprise de contact inférieure) avec gravure de la couche diélectrique et la couche conductrice inférieure de la MIM avec sur gravure et retrait de la résine (« stripping »),
- dépôt de SiN ou SiO₂ (passivation) + litho + gravure sur les électrodes supérieure 60 et inférieure 70, puis retrait de la résine (« stripping »),
- dépôt de métal, lithographie, gravure du métal avec arrêt sur la passivation (SiN ou SiO₂).

Alternativement, il est possible de dissocier la formation de la zone capacitive et de la zone de reprise de contact.

Par exemple, on peut masquer la zone capacitive et faire un dépôt métallique par ALD ou une croissance ECD (par exemple Ni ou W ou Cu) dans la zone de reprise de contact. Ceci permet de limiter le nombre de dépôts ALD.

Le procédé peut, en outre, comprendre l'isolement de l'électrode inférieure des différents composants et accessoirement la génération de chemins de découpe ou tranchées 80 pour discrétiser les composants. Le procédé comprend alors en outre les étapes suivantes :
- gravure humide de la couche d'alumine poreuse 21 pour un « élargissement latéral de pores »,
- gravure de la couche d'arrêt 13 en tungstène,
- gravure de la couche métallique 10 conductrice en AlCu.

## Revendications

1. Procédé de fabrication d'un dispositif capacitif comprenant les étapes suivantes :
a) fournir une couche métallique (10),
b) déposer une couche d'aluminium (20) pleine plaque,
c) structurer des pores dans la couche d'aluminium (20) par un procédé de gravure anodique pleine plaque, moyennant quoi on obtient une couche d'alumine poreuse continue (21) comprenant une première face principale (21a) et une deuxième face principale (21b), des pores longitudinaux allant de la première face principale (21a) à la deuxième face principale (21b) de la couche d'alumine,
d) déposer un empilement capacitif au niveau d'une première zone (Z1) de la couche d'alumine poreuse (21), moyennant quoi on forme une zone capacitive,
e) former une électrode supérieure (60) sur la zone capacitive,
f) former une reprise de contact au niveau d'une deuxième zone (Z2) de la couche d'alumine poreuse (21),
g) former une électrode inférieure (70) sur la reprise de contact.

2. Procédé selon la revendication 1, **caractérisé en ce que** l'étape d) comprend les sous-étapes suivantes :
d1) sur la couche d'alumine poreuse (21), former un masque (50) ayant une ouverture rendant accessible la première zone (Z1) de la couche d'alumine poreuse (21),
d2) déposer un premier empilement capacitif (30) continu sur la première zone (Z1) de la couche d'alumine poreuse (21), le premier empilement capacitif (30) recouvrant de manière conforme la couche d'alumine poreuse (21) et tapissant de manière conforme les pores de la couche d'alumine poreuse (21), au niveau de la première zone (Z1),
le premier empilement capacitif comprenant une couche conductrice supérieure (33), une couche isolante (32) et une couche conductrice inférieure (31).

3. Procédé selon l'une des revendications 1 et 2, **caractérisé en ce que** l'étape f) comprend les sous-étapes suivantes :
f1) sur la couche d'alumine poreuse (21), former un masque (50) ayant une ouverture rendant accessible la deuxième zone (Z2) de la couche d'alumine poreuse (21),
f2) déposer un deuxième empilement capacitif (40) continu sur la deuxième zone (Z2) de la couche d'alumine poreuse, le deuxième empilement capacitif (40) recouvrant de manière conforme la couche d'alumine poreuse (21) et tapissant de manière conforme les pores de la couche d'alumine poreuse (21), au niveau de la deuxième zone (Z2),
f3) graver le deuxième empilement capacitif (40) au niveau de la deuxième zone (Z2) de la couche d'alumine poreuse (21) de manière à rendre accessible la seconde face (21b) de la couche d'alumine poreuse (21) au niveau de la deuxième zone (Z2),
le deuxième empilement capacitif (40) comprenant une couche conductrice supérieure (43), une couche isolante (42) et une couche conductrice inférieure (41).

4. Procédé selon les revendications 2 et 3, **caractérisé en ce que** les étapes d1) et f1) sont réalisées simultanément et/ou les étapes d2) et f2) sont réalisées simultanément.

5. Procédé selon l'une des revendications 2, 3 et 4, **caractérisé en ce que** le premier empilement capacitif (30) et le deuxième empilement capacitif (40) sont identiques et déposés simultanément par ALD.

6. Procédé selon la revendication 1, **caractérisé en ce que** l'étape d) comprend les sous-étapes suivantes :
d1') sur la couche d'alumine poreuse, former un masque ayant une ouverture rendant accessible la première zone (Z1) de la couche d'alumine poreuse (21),
d2') former des nanofils métalliques ou nanotubes de carbone par électrochimie dans les pores de la couche d'alumine poreuse (21) au niveau de la première zone (Z1),
d3') retirer la couche d'alumine poreuse (21) au niveau de la première zone (Z1),
d4') déposer un empilement capacitif continu sur les nanofils métalliques ou sur les nanotubes de carbone, au niveau de la première zone (Z1), l'empilement capacitif recouvrant de manière conforme les nanofils métalliques ou les nanotubes de carbone,
l'empilement capacitif comprenant une couche conductrice supérieure, une couche isolante et éventuellement une couche conductrice inférieure.

7. Procédé selon l'une des revendications 1 et 6, **caractérisé en ce que** l'étape f) comprend les sous-étapes suivantes :
f1') sur la couche d'alumine poreuse (21), former un masque ayant une ouverture rendant accessible la deuxième zone (Z2) de la couche d'alumine poreuse (21),
f2') former des nanofils métalliques ou nanotubes de carbone par électrochimie dans les pores de la couche d'alumine poreuse (21) au niveau de la deuxième zone (Z2),
f3') retirer la couche d'alumine poreuse (21) au niveau de la deuxième zone (Z2),
f4') déposer un empilement capacitif continu sur les nanofils métalliques ou sur les nanotubes de carbone, au niveau de la deuxième zone (Z2), l'empilement capacitif recouvrant de manière conforme les nanofils métalliques ou les nanotubes de carbone,
l'empilement capacitif comprenant une couche conductrice supérieure, une couche isolante et éventuellement une couche conductrice inférieure.

8. Procédé selon l'une quelconque des revendications précédentes, **caractérisé en ce que** l'étape f) comprend les sous-étapes suivantes :
- sur la couche d'alumine poreuse, former un masque ayant une ouverture rendant accessible la deuxième zone (Z2) de la couche d'alumine poreuse (21),
- remplir totalement ou partiellement les pores de la couche d'alumine poreuse (21) au niveau de la deuxième zone (Z2), avec un élément électriquement conducteur, comme du cuivre, du tungstène ou du nickel, par dépôt électrochimique ou par dépôt de couches atomiques.

9. Procédé selon l'une quelconque des revendications précédentes, **caractérisé en ce que** la couche métallique (10) repose sur un substrat support (11) recouvert d'une couche diélectrique (12) et **en ce que** le procédé comporte une étape au cours de laquelle on forme, par exemple par gravure humide, une tranchée (80) dans la couche d'alumine poreuse (21), la tranchée (80) allant jusqu'à la couche diélectrique (12) recouvrant le substrat support (11).

10. Procédé selon l'une quelconque des revendications précédentes, **caractérisé en ce qu'**une couche barrière (13), de préférence en tungstène, est disposée entre la couche métallique (10) et la couche d'aluminium (20).

11. Procédé selon l'une quelconque des revendications précédentes, **caractérisé en ce que** la couche d'alumine poreuse (21) a une épaisseur allant de 10 à 15µm.

12. Dispositif capacitif obtenu selon l'une quelconque des revendications 1 à 5 et 8 à 11 comprenant :
- une couche métallique (10), de préférence à base d'aluminium, par exemple en AlCu,
- une couche d'alumine poreuse continue (21) comprenant une première face principale (21a) et une seconde face principale (21b), la couche d'alumine poreuse (21) comprenant des pores traversant allant de la première face principale (21a) à la deuxième face principale (21b),
- un premier empilement capacitif (30) continu recouvrant de manière conforme la seconde face (21b) de la couche d'alumine poreuse (21) et tapissant de manière conforme les pores de la couche d'alumine poreuse (21) au niveau d'une première zone (Z1) de la couche d'alumine poreuse (21), de manière à former une zone capacitive, le premier empilement capacitif (30) comprenant une couche conductrice supérieure, par exemple en TiN, une couche isolante par exemple en Al₂O₃, et éventuellement une couche conductrice inférieure par exemple en TiN.
- une électrode supérieure (60) recouvrant la zone capacitive,
- un élément électriquement conducteur replissant partiellement ou totalement les pores de la couche d'alumine poreuse (21) au niveau d'une deuxième zone (Z2), et laissant accessible la seconde face principale (21b) de la couche d'alumine poreuse (21) au niveau de la deuxième zone (Z2), de manière à former une reprise de contact, l'élément électriquement conducteur étant de préférence un deuxième empilement capacitif continu (40) tapissant de manière conforme les pores de la couche d'alumine poreuse (21) au niveau de la deuxième zone (Z2) de la couche d'alumine poreuse (21), le deuxième empilement capacitif (40), étant avantageusement identique au premier empilement capacitif,
- une électrode inférieure (70) recouvrant la reprise de contact.

13. Dispositif selon la revendication précédente, **caractérisé en ce que** le dispositif comprend une zone d'isolement formée d'une tranchée (80) dans la couche d'alumine poreuse (21), la tranchée allant jusqu'à la couche diélectrique (12) recouvrant le substrat support (11).

## Patentansprüche

1. Verfahren zur Herstellung einer kapazitiven Vorrichtung, das folgende Schritte umfasst:
a) Bereitstellen einer metallischen Schicht (10),
b) Aufbringen einer durchgehenden Aluminiumschicht (20),
c) Strukturieren von Poren in der Aluminiumschicht (20) durch ein Vollplatten-Anodenätzverfahren, wodurch eine durchgehende poröse Aluminiumoxidschicht (21) erhalten wird, die eine erste Hauptseite (21a) und eine zweite Hauptseite (21b) umfasst, wobei Längsporen von der ersten Hauptseite (21a) bis zu der zweiten Hauptseite (21b) der Aluminiumoxidschicht verlaufen,
d) Aufbringen eines kapazitiven Stapels auf Höhe eines ersten Bereichs (Z1) der porösen Aluminiumoxidschicht (21), wodurch ein kapazitiver Bereich gebildet wird,
e) Bilden einer oberen Elektrode (60) auf dem kapazitiven Bereich,
f) Bilden einer Kontaktübernahme auf Höhe eines zweiten Bereichs (Z2) der porösen Aluminiumoxidschicht (21),
g) Bilden einer unteren Elektrode (70) an der Kontaktübernahme.

2. Verfahren nach Anspruch 1, **dadurch gekennzeichnet, dass** Schritt d) die folgenden Unterschritte umfasst:
d1) auf der porösen Aluminiumoxidschicht (21), Bilden einer Maske (50), die eine Öffnung aufweist, die den ersten Bereich (Z1) der porösen Aluminiumoxidschicht (21) zugänglich macht,
d2) Aufbringen eines ersten durchgehenden kapazitiven Stapels (30) auf dem ersten Bereich (Z1) der porösen Aluminiumoxidschicht (21), wobei der erste kapazitive Stapel (30) die poröse Aluminiumoxidschicht (21) konform bedeckt und die Poren der porösen Aluminiumoxidschicht (21) auf Höhe des ersten Bereichs (Z1) konform auskleidet,
wobei der erste kapazitive Stapel eine obere leitfähige Schicht (33), eine Isolierschicht (32) und eine untere leitfähige Schicht (31) umfasst.

3. Verfahren nach einem der Ansprüche 1 und 2, **dadurch gekennzeichnet, dass** Schritt f) die folgenden Unterschritte umfasst:
f1) auf der porösen Aluminiumoxidschicht (21), Bilden einer Maske (50), die eine Öffnung aufweist, die den zweiten Bereich (Z2) der porösen Aluminiumoxidschicht (21) zugänglich macht,
f2) Aufbringen eines zweiten durchgehenden kapazitiven Stapels (40) auf den zweiten Bereich (Z2) der porösen Aluminiumoxidschicht, wobei der zweite kapazitive Stapel (40) die poröse Aluminiumoxidschicht (21) konform bedeckt und die Poren der porösen Aluminiumoxidschicht (21) auf Höhe des zweiten Bereichs (Z2) konform auskleidet,
f3) Ätzen des zweiten kapazitiven Stapels (40) auf Höhe des zweiten Bereichs (Z2) der porösen Aluminiumoxidschicht (21), so dass die zweite Seite (21b) der porösen Aluminiumoxidschicht (21) auf Höhe des zweiten Bereichs (Z2) zugänglich wird,
wobei der zweite kapazitive Stapel (40) eine obere leitfähige Schicht (43), eine Isolierschicht (42) und eine untere leitfähige Schicht (41) umfasst.

4. Verfahren nach Anspruch 2 und 3, **dadurch gekennzeichnet, dass** die Schritte d1) und f1) gleichzeitig durchgeführt werden und/oder die Schritte d2) und f2) gleichzeitig durchgeführt werden.

5. Verfahren nach einem der Ansprüche 2, 3 und 4, **dadurch gekennzeichnet, dass** der erste kapazitive Stapel (30) und der zweite kapazitive Stapel (40) identisch sind und gleichzeitig durch ALD aufgebracht werden.

6. Verfahren nach Anspruch 1, **dadurch gekennzeichnet, dass** Schritt d) die folgenden Unterschritte umfasst:
d1') auf der porösen Aluminiumoxidschicht, Bilden einer Maske mit einer Öffnung, die den ersten Bereich (Z1) der porösen Aluminiumoxidschicht (21) zugänglich macht,
d2') elektrochemisches Bilden von Metallnanodrähten oder Kohlenstoffnanoröhrchen in den Poren der porösen Aluminiumoxidschicht (21) auf Höhe des ersten Bereichs (Z1),
d3') Abtragen der porösen Aluminiumoxidschicht (21) auf Höhe des ersten Bereichs (Z1),
d4') Aufbringen eines durchgehenden kapazitiven Stapels auf die Metallnanodrähte oder auf die Kohlenstoffnanoröhrchen auf Höhe des ersten Bereichs (Z1), wobei der kapazitive Stapel die Metallnanodrähte oder Kohlenstoffnanoröhrchen konform bedeckt,
wobei der kapazitive Stapel eine obere leitfähige Schicht, eine Isolierschicht und gegebenenfalls eine untere leitfähige Schicht umfasst.

7. Verfahren nach einem der Ansprüche 1 und 6, **dadurch gekennzeichnet, dass** Schritt f) die folgenden Unterschritte umfasst:
f1') auf der porösen Aluminiumoxidschicht (21), Bilden einer Maske mit einer Öffnung, die den zweiten Bereich (Z2) der porösen Aluminiumoxidschicht (21) zugänglich macht,
f2') elektrochemisches Bilden von Metallnanodrähten oder Kohlenstoffnanoröhrchen in den Poren der porösen Aluminiumoxidschicht (21) auf Höhe des zweiten Bereichs (Z2),
f3') Abtragen der porösen Aluminiumoxidschicht (21) auf Höhe des zweiten Bereichs (Z2),
f4') Aufbringen eines durchgehenden kapazitiven Stapels auf die Metallnanodrähte oder auf die Kohlenstoffnanoröhrchen auf Höhe des zweiten Bereichs (Z2), wobei der kapazitive Stapel die metallischen Nanodrähte oder die Kohlenstoffnanoröhrchen konform bedeckt,
wobei der kapazitive Stapel eine obere leitfähige Schicht, eine Isolierschicht und gegebenenfalls eine untere leitfähige Schicht umfasst.

8. Verfahren nach einem der vorhergehenden Ansprüche, **dadurch gekennzeichnet, dass** Schritt f) die folgenden Unterschritte umfasst:
- auf der porösen Aluminiumoxidschicht, Bilden einer Maske mit einer Öffnung, die den zweiten Bereich (Z2) der porösen Aluminiumoxidschicht (21) zugänglich macht,
- ganzes oder teilweises Füllen der Poren der porösen Aluminiumoxidschicht (21) auf Höhe des zweiten Bereichs (Z2) mit einem elektrisch leitenden Element wie Kupfer, Wolfram oder Nickel durch elektrochemische Ablagerung oder durch Ablagerung von Atomschichten.

9. Verfahren nach einem der vorhergehenden Ansprüche, **dadurch gekennzeichnet, dass** die Metallschicht (10) auf einem Trägersubstrat (11) aufliegt, das mit einer dielektrischen Schicht (12) bedeckt ist, und dass das Verfahren einen Schritt aufweist, bei dem beispielsweise durch Nassätzen ein Graben (80) in der porösen Aluminiumoxidschicht (21) gebildet wird, wobei der Graben (80) bis zu der dielektrischen Schicht (12) reicht, die das Trägersubstrat (11) bedeckt.

10. Verfahren nach einem der vorhergehenden Ansprüche, **dadurch gekennzeichnet, dass** zwischen der Metallschicht (10) und der Aluminiumschicht (20) eine Barriereschicht (13), vorzugsweise aus Wolfram, angeordnet ist.

11. Verfahren nach einem der vorhergehenden Ansprüche, **dadurch gekennzeichnet, dass** die poröse Aluminiumoxidschicht (21) eine Dicke von 10 bis 15 µm besitzt.

12. Kapazitive Vorrichtung gemäß einem der Ansprüche 1 bis 5 und 8 bis 11, umfassend:
- eine metallische Schicht (10), vorzugsweise auf Aluminiumbasis, beispielsweise aus AlCu,
- eine durchgehende poröse Aluminiumoxidschicht (21), die eine erste Hauptseite (21a) und eine zweite Hauptseite (21b) umfasst, wobei die poröse Aluminiumoxidschicht (21) durchgehende Poren umfasst, die von der ersten Hauptseite (21a) bis zu der zweiten Hauptseite (21b) verlaufen,
- einen ersten durchgehenden kapazitiven Stapel (30), der die zweite Seite (21b) der porösen Aluminiumoxidschicht (21) konform bedeckt und die Poren der porösen Aluminiumoxidschicht (21) auf Höhe eines ersten Bereichs (Z1) der porösen Aluminiumoxidschicht (21) konform auskleidet, um einen kapazitiven Bereich zu bilden, wobei der erste kapazitive Stapel (30) eine obere leitfähige Schicht, beispielsweise aus TiN, eine Isolierschicht, beispielsweise aus Al₂O ₃, umfasst, und eventuell eine untere leitfähige Schicht z.B. aus TiN.
- eine obere Elektrode (60), die den kapazitiven Bereich abdeckt,
- ein elektrisch leitfähiges Element, das die Poren der porösen Aluminiumoxidschicht (21) auf Höhe eines zweiten Bereichs (Z2) teilweise oder vollständig zusammenfaltet und die zweite Hauptseite (21b) der porösen Aluminiumoxidschicht (21) auf Höhe des zweiten Bereichs (Z2) zugänglich macht, um eine Kontaktübernahme zu bilden, wobei das elektrisch leitfähige Element vorzugsweise ein zweiter durchgehender kapazitiver Stapel (40) ist, der die Poren der porösen Aluminiumoxidschicht (21) auf Höhe des zweiten Bereichs (Z2) der porösen Aluminiumoxidschicht (21) konform auskleidet, wobei der zweite kapazitive Stapel (40) vorteilhaft identisch mit dem ersten kapazitiven Stapel ist,
- eine untere Elektrode (70), die die Kontaktübernahme abdeckt.

13. Vorrichtung nach dem vorhergehenden Anspruch, **dadurch gekennzeichnet, dass** die Vorrichtung einen Isolationsbereich umfasst, der aus einem Graben (80) in der porösen Aluminiumoxidschicht (21) gebildet ist, wobei der Graben bis zu der dielektrischen Schicht (12) verläuft, die das Trägersubstrat (11) bedeckt.

## Claims

1. Method for manufacturing a capacitive device comprising the following steps:
a) providing a metallic layer (10),
b) depositing a full-surface aluminium layer (20),
c) structuring pores in the aluminium layer (20) by a full-surface anodic etching process, by means of which a continuous porous alumina layer (21) is obtained comprising a first main face (21a) and a second main face (21b), longitudinal pores extending from the first main face (21a) to the second main face (21b) of the alumina layer,
d) depositing a capacitive stack at a first area (Z1) of the porous alumina layer (21), by means of which a capacitive area is formed,
e) forming an upper electrode (60) over the capacitive area,
f) forming an establishment of contact at a second area (Z2) of the porous alumina layer(21),
g) forming a lower electrode over the establishment of contact.

2. Method according to claim 1, **characterised in that** step d) comprises the following substeps:
d1) over the porous alumina layer (21), forming a mask (50) having an opening making the first area (Z1) of the porous alumina layer (21) accessible,
d2) depositing a first continuous capacitive stack (30) over the first area (Z1) of the porous alumina layer (21), the first capacitive stack (30) conformally covering the porous alumina layer (21) and conformally overlaying the pores of the porous alumina layer, at the first area,
the first capacitive stack comprising an upper conductive layer (33), an insulating layer (32) and a lower conductive layer (31).

3. Method according to claims 1 and 2, **characterised in that** step f) comprises the following substeps:
f1) over the porous alumina layer (21), forming a mask (50) having an opening making the second area (Z2) of the porous alumina layer (21) accessible,
f2) depositing a second continuous capacitive stack (40) over the second area (Z2) of the porous alumina layer, the second capacitive stack (40) conformally covering the porous alumina layer (21) and conformally overlaying the pores of the porous alumina layer (21), at the second area (Z2),
f3) etching the second capacitive stack (40) at the second area (Z2) of the porous alumina layer (21) so as to make the second face (21b) of the porous alumina layer (21) accessible at the second area,
the second capacitive stack (40) comprising an upper conductive layer (43), an insulating layer (42) and a lower conductive layer (41).

4. Method according to claims 2 and 3, **characterised in that** steps d1) and f1) are carried out simultaneously and/or steps d2) and f2) are carried out simultaneously.

5. Method according to one of claims 2, 3 and 4, **characterised in that** the first capacitive stack (30) and the second capacitive stack (40) are identical and deposited simultaneously by ALD.

6. Method according to claim 1, **characterised in that** step d) comprises the following substeps:
d1') over the porous alumina layer, forming a mask having an opening making the first area (Z1) of the porous alumina layer (21) accessible,
d2') forming metallic nanowires or carbon nanotubes by electrochemistry in the pores of the alumina layer (21) at the first area (Z1),
d3') removing the porous alumina layer (21) at the first area (Z1),
d4') depositing a continuous capacitive stack over the metallic nanowires or over the carbon nanotubes, at the first area (Z1), the capacitive stack conformally covering the metallic nanowires or the carbon nanotubes,
the capacitive stack comprising an upper conductive layer, an insulating layer and optionally a lower conductive layer.

7. Method according to claims 1 and 6, **characterised in that** step f) comprises the following substeps:
f1') over the porous alumina layer (21), forming a mask having an opening making the second area (Z2) of the porous alumina layer (21) accessible,
f2') forming metallic nanowires or carbon nanotubes by electrochemistry in the pores of the porous alumina layer (21) at the second area (Z2),
f3') removing the porous alumina layer (21) at the second area (Z2),
f4') depositing a continuous capacitive stack over the metallic nanowires or over the carbon nanotubes, at the second area (Z2), the capacitive stack conformally covering the metallic nanowires or the carbon nanotubes,
the capacitive stack comprising an upper conductive layer, an insulating layer and optionally a lower conductive layer.

8. Method according to any one of the preceding claims, **characterised in that** step f) comprises the following substeps:
- over the porous alumina layer, forming a mask having an opening making the second area (Z2) of the porous alumina layer (21) accessible,
- totally or partially filling the pores of the porous alumina layer (21) at the second area (Z2), with an electrically-conductive element, such as copper, tungsten or nickel, by electrochemical deposition or by atomic layer deposition.

9. Method according to any one of the preceding claims, **characterised in that** the metallic layer (10) rests on a support substrate (11) covered by a dielectric layer (12) and **in that** the method includes a step during which a trench is formed, for example by wet etching, in the porous alumina layer (21), the trench (80) extending up to the dielectric layer (12) covering the support substrate (11).

10. Method according to any one of the preceding claims, **characterised in that** a barrier layer (13), preferably of tungsten, is disposed between the metallic layer (10) and the aluminium layer (20).

11. Method according to any one of the preceding claims, **characterised in that** the porous alumina layer (21) has a thickness ranging from 10 to 15 µm.

12. Capacitive device obtained according to any one of claims 1 to 5 and 8 to 11, comprising:
- a metallic layer (10), preferably based on aluminium, for example AlCu,
- a continuous porous alumina layer (21) comprising a first main face (21a) and a second main face (21b), the porous alumina layer (21) comprising through pores extending from the first main face (21a) to the second main face (21b),
- a first continuous capacitive stack (30) conformally covering the second face (21b) of the porous alumina layer (21) and conformally overlaying the pores of the porous alumina layer (21) at a first area (Z1) of the porous alumina layer (21), so as to form a capacitive area, the first capacitive stack (30) comprising an upper conductive layer, for example made of TiN, an insulating layer for example made of Al₂O₃, and optionally a lower conductive layer for example made of TiN,
- an upper electrode (60) covering the capacitive area,
- an electrically-conductive element partially or totally filling the pores of the porous alumina layer (21) at a second area (Z2), and leaving the second main face (21b) of the porous alumina layer (21) accessible at the second area (Z2), so as to form an establishment of contact, the electrically conductive element preferably being a second continuous capacitive stack (40) conformally overlaying the pores of the porous alumina layer (21) at the second area (Z2) of the porous alumina layer (21), the second capacitive stack (40) advantageously being identical to the first capacitive stack,
- a lower electrode (70 covering the establishment of contact.

13. Device according to the preceding claim, **characterised in that** the device comprises an insulation area formed by a trench (80) in the porous alumina layer (21), the trench extending up to the dielectric layer (12) covering the support substrate (11).
